# EUROPEAN PATENT APPLICATION

(11) **EP 2 819 149 A1**
(43) Date of publication of application: **31.12.2014**
(21) Application number: 13751158.0
(22) Date of filing: 10.01.2013
(51) Int. Cl.: H01L 21/225, C03C 8/16, C08L 101/00, C09D 201/00, H01L 31/04

(54) **COMPOSITION FOR FORMING N-TYPE DIFFUSION LAYER, METHOD FOR PRODUCING SEMICONDUCTOR SUBSTRATE HAVING N-TYPE DIFFUSION LAYER, AND METHOD FOR PRODUCING SOLAR CELL ELEMENT**

(30) Priority: 23.02.2012 JP 2012037384
(71) Applicant: Hitachi Chemical Company, Ltd., Chiyoda-ku Tokyo 100-6606 (JP)
(72) Inventor: SATO, Tetsuya, Tsukuba-shi Ibaraki 300-4247 (JP); YOSHIDA, Masato, Tsukuba-shi Ibaraki 300-4247 (JP); NOJIRI, Takeshi, Tsukuba-shi Ibaraki 300-4247 (JP); ASHIZAWA, Toranosuke, Hitachi-shi Ibaraki 317-8555 (JP); KURATA, Yasushi, Tsukuba-shi Ibaraki 300-4247 (JP); MACHII, Yoichi, Tsukuba-shi Ibaraki 300-4247 (JP); IWAMURO, Mitsunori, Tsukuba-shi Ibaraki 300-4247 (JP); ORITA, Akihiro, Tsukuba-shi Ibaraki 300-4247 (JP); SHIMIZU, Mari, Tsukuba-shi Ibaraki 300-4247 (JP)
(74) Representative: Hoffmann Eitle
(86) International application number: PCT/JP2013/050305
(87) International publication number: WO 2013/125253

(57) **Abstract**

The invention provides composition for forming an n-type diffusion layer, the composition comprising a compound containing a donor element, a dispersing medium, and an organic filler; a method for producing a semiconductor substrate having an n-type diffusion layer; and a method for producing a photovoltaic cell element.

## Description

### Technical Field

The present invention relates to a composition for forming n-type diffusion layer, a method for producing a semiconductor substrate having an n-type diffusion layer, and a method for producing a solar cell element.

### Background Art

A conventional method for producing a silicon photovoltaic cell element (a photovoltaic cell element) will be described below. First, a p-type semiconductor substrate, in which a textured structure is formed on a light-receiving surface in order to increase efficiency by promoting a light trapping effect, is prepared. Next, an n-type diffusion layer is uniformly formed by performing a treatment in an atmosphere of a mix gas of phosphorus oxychloride (POCl₃), nitrogen and oxygen, at from 800°C to 900°C for several tens of minutes. In this conventional method, an n-type diffusion layer is formed not only at a top surface but also at side surfaces and a back surface, because phosphorus diffusion is performed with a mix gas. Therefore, a side etching step needs to be performed in order to remove the n-type diffusion layer formed at side surfaces. Further, the n-type diffusion layer formed at the back side needs to be converted to a p⁺-type diffusion layer. For this purpose, an aluminum paste containing aluminum, which is a group 13 element, is applied onto the n-type diffusion layer formed at the back surface and a thermal treatment is performed, whereby the n-type diffusion layer is converted to a p⁺-type diffusion layer by diffusion of aluminum and an ohmic contact is also established.

Further, a method of forming an n-type diffusion layer by applying a solution containing a phosphate such as ammonium dihydrogen phosphate (NH₄H₂PO₄) has been proposed (see, for example, Japanese Patent Application Laid-Open (JP-A) No. 2002-75894). However, even in this method, a phosphorus compound diffuses from the region at which the solution has been applied during a thermal treatment. As a result, a donor element is not diffused in a selective manner and an n-type diffusion layer is formed over the entire surfaces.

In connection with the above, a method for producing a photovoltaic cell element, in which an n-type diffusion layer is formed only at a specific region without forming unnecessary n-type diffusion layers at side and back surfaces of a semiconductor substrate, has been proposed (see, for example, International Publication No. WO11/090216). In this method, an n-type diffusion layer is formed by applying a composition for forming an n-type diffusion layer that contains glass particles including a donor element, and a dispersing medium, onto a semiconductor substrate and performing a thermal treatment.

As a structure of a photovoltaic cell element that attains a higher conversion efficiency, a selective emitter structure, in which a diffusion concentration of a donor element (hereinafter, also referred to as a "diffusion concentration") at a region other than a region immediately beneath an electrode is lower than that at the region immediately beneath an electrode, has been known (see, for example, L. Debarge, M. Schott, J. C. Muller, and R. Monna, Solar Energy Materials & Photovoltaic cells, 74 (2002) 71-75). In this structure, since a region having a higher diffusion concentration is formed at a region immediately beneath an electrode (hereinafter, also referred to as a "selective emitter") is formed, the contact resistance between an electrode and a semiconductor substrate can be reduced. Further, since the diffusion concentration at a region other than the region at which an electrode is formed is relatively low, the conversion efficiency of a photovoltaic cell element can be improved. In order to obtain a selective emitter structure, it is required to form an n-type diffusion layer in the form of a fine line having a width of within several hundred micrometers (approximately from 50 µm to 250 µm).

### Summary of the Invention

### Technical Problem

In a case of a composition for forming an n-type diffusion layer described in WO 11/090216, a desired width of a line tends not to be obtained due to expansion thereof, even when the composition for forming an n-type diffusion layer is applied onto a semiconductor substrate in a shape of a fine line. If the viscosity is increased by changing the content of a dispersing medium in order to overcome this problem, the composition tends to become hard to handle and unable to be applied to a semiconductor substrate.

The invention has been accomplished in view of these conventional problems, and aims to provide a composition for forming an n-type diffusion layer that is capable of forming a fine-line n-type diffusion layer while suppressing expansion of the line width, a method for producing a semiconductor substrate having an n-type diffusion layer, and a method for producing a photovoltaic cell element.

### Solution to Problem

The means for solving the problem are as follows.
<1> A composition for forming an n-type diffusion layer, the composition comprising a compound containing a donor element, a dispersing medium, and an organic filler.
<2> The composition for forming an n-type diffusion layer according to <1>, wherein the organic filler is in a form of particles having an average particle size of 10 µm or less.
<3> The composition for forming an n-type diffusion layer according to <1> or <2>, wherein the degradation temperature of the organic filler is 700°C or less.
<4> The composition for forming an n-type diffusion layer according to any one of <1> to <3>, wherein the compound containing a donor element is a compound containing phosphorus.
<5> The composition for forming an n-type diffusion layer according to any one of <1> to <4>, wherein the compound containing a donor element is in a form of glass particles.
<6> The composition for forming an n-type diffusion layer according to <5>, wherein the glass particles comprise at least one substance containing a donor element selected from the group consisting of P₂O₃ and P₂O₅, and at least one glass component substance selected from the group consisting of SiO₂, K₂O, Na₂O, Li₂O, BaO, SrO, CaO, MgO, BeO, ZnO, PbO, CdO, V₂O₅, SnO, ZrO₂ and MoO₃.
<7> The composition for forming an n-type diffusion layer according to <5> or <6>, wherein a content of the glass particles in the composition for forming an n-type diffusion layer is from 1 mass% to 80 mass%.
<8> The composition for forming an n-type diffusion layer according to any one of <5> to <7>, wherein a content of the at least one substance containing a donor element selected from the group consisting of P₂O₃ and P₂O₅ in the glass particles is from 0.01 mass% to 10 mass%.
<9> The composition for forming an n-type diffusion layer according to any one of <1> to <8>, wherein a content of the organic filler in the composition for forming an n-type diffusion layer is from 1 mass% to 50 mass%.
<10> A method for producing a semiconductor substrate having an n-type diffusion layer, the method comprising: a process of applying the composition for forming an n-type diffusion layer according to any one of <1> to <9> onto at least a part of a semiconductor substrate; and a process of forming an n-type diffusion layer in the semiconductor substrate by performing a heat treatment.
<11> A method for producing a photovoltaic cell element, the method comprising: a process of applying the composition for forming an n-type diffusion layer according to any one of <1> to <9> onto at least a part of a semiconductor substrate; a process of forming an n-type diffusion layer in the semiconductor substrate by performing a heat treatment; and a process of forming an electrode on the n-type diffusion layer.

### Advantageous Effect of the Invention

According to the invention, it is possible to provide a composition for forming an n-type diffusion layer that is capable of forming a fine-line n-type diffusion layer while suppressing expansion of the line width, a method for producing a semiconductor substrate having an n-type diffusion layer, and a method for producing a photovoltaic cell element.

### Brief Description of Drawings

Figure 1 is a conceptual cross-sectional view showing an example of the processes for producing a photovoltaic cell element according to the present embodiment.
Figure 2 is a plan view of a photovoltaic cell element viewed from the top surface side according to the embodiment.
Figure 3 is an enlarged perspective view of a part of Figure 2.

### Description of Embodiments

In the present specification, the term "process" includes herein not only an independent process, but also a process that cannot be clearly distinguished from other processes, insofar as an intended function of the process can be attained. A numerical range expressed by "from x to y" includes x and y as the minimum and maximum values, respectively. When there are plural substances that correspond to a component of a composition, the content of the component refers to a total of the plural substances in the composition, unless otherwise specified. The term "content" refers to a percentage by mass with respect to 100 mass% of the composition for forming an n-type diffusion layer, unless otherwise specified.

### <Composition for forming n-type diffusion layer>

The composition for forming an n-type diffusion layer according to the invention includes a compound containing a donor element, a dispersing medium, and an organic filler. As necessary, the composition may include other additives in view of application suitability and the like. The composition for forming an n-type diffusion layer refers to a material that includes a donor element and is capable of forming an n-type diffusion layer by thermally diffusing the donor element after applying the composition onto a semiconductor substrate. Since the composition for forming an n-type diffusion layer according to the invention includes a composition containing a donor element and an organic filler, it can form an n-type diffusion layer only at a desired region without forming an n-type diffusion layer at a region at which an n-type diffusion layer is not to be formed. In addition, in a case in which the n-type diffusion layer is a fine line, it is possible to form an n-type diffusion layer while suppressing expansion of the line width.

Consequently, in a case of production of a conventional photovoltaic cell element to which the composition for forming an n-type diffusion layer according to the invention is applied, processes can be simplified by omitting side etching, which is an essential process in a gas phase reaction method. Further, a process of converting an n-type diffusion layer formed at a back surface to a p⁺-type diffusion layer becomes unnecessary. As a result, since there is no restriction on the method for forming a p⁺-type diffusion layer at a back surface, the material, the shape, and the thickness of the back side electrode, it is possible to select production method, the material and the shape from wide ranges of choices. In addition, as described below, development of an internal stress in a semiconductor substrate that is due to the thickness of a back side electrode can be suppressed, and warpage of the semiconductor substrate can be suppressed. Further, in the production of a photovoltaic cell element having a selective emitter structure or the like, in which an n-type diffusion layer is formed in a shape of a fine line, the n-type diffusion layer can be formed only at a position beneath an electrode with high accuracy. Therefore, it is possible to simplify the production process by omitting formation of a mask on a semiconductor substrate for preventing formation of an unnecessary n-type diffusion layer.

### (Compound containing donor element)

The composition for forming an n-type diffusion layer according to the invention includes a compound containing a donor element. A donor element refers to an element that is capable of diffusing into a semiconductor substrate to form an n-type diffusion layer. As a donor element, an element that belongs to group 15 can be used. From a viewpoint of safety and the like, P (phosphorus) is preferred.

There is no particular restriction on a compound containing a donor element. For example, a metal oxide containing a donor element can be used. Examples of a metal oxide containing a donor element include a single metal oxide, such as P₂O₅ and P₂O₃; an inorganic phosphorus compound, such as phosphorus silicide, silicon particles doped with phosphorus, calcium phosphate, phosphoric acid, and glass particles containing phosphorus; and an organic phosphorus compound, such as phosphonic acid, phosphonous acid, phosphinic acid, phosphinous acid, phosphine, phosphine oxide, a phosphate ester, and a phosphite ester.

Among these, the donor element is preferably one or more selected from the group consisting of P₂O₃, P₂O₅, and a compound that can convert into a compound containing P₂O₅ at a temperature of a thermal treatment for diffusing a donor element to a semiconductor substrate (for example, 800°C or higher) such as ammonium dihydrogen phosphate, phosphoric acid, phosphonous acid, phosphinic acid, phosphinous acid, phosphine, phosphine oxide, a phosphate ester and a phosphite ester. Among these, a compound having a melting point of 1000°C or less is more preferable. This is because a compound containing a donor element readily becomes molten while performing thermal diffusion into a semiconductor substrate, which facilitates uniform diffusion of the donor element into a semiconductor substrate. Specifically, as such a compound, at least one selected from the group consisting of P₂O₅ and glass particles containing phosphorus is preferred. In a case in which the melting point of a compound containing a donor element exceeds 1000°C, it is possible to add a compound having a melting point of below 1000°C such that the donor element is allowed to diffuse into a semiconductor substrate via the compound having a melting point of below 1000°C from the compound containing the donor element.

The compound containing a donor element may be in a state in which particles of the composition for forming an n-type diffusion layer is dispersed in a dispersion medium, or in a state in which the compound containing a donor element is dissolved in a dispersion medium. In a case in which the compound containing a donor element is in the form of solid particles, examples of the shape thereof include nearly spherical, flat, blockish, platy, and squamous. From the viewpoint of application suitability of the composition for forming an n-type diffusion layer onto a substrate or uniform diffusibility, the shape of the particle is preferably nearly spherical, flat or platy. In a case in which a compound containing a donor element is in the shape of solid particles, the particle size is preferably 100 µm or less. In a case in which particles having a particle size of 100 µm or less are applied onto a semiconductor substrate, a flat and smooth layer of a composition for forming an n-type diffusion layer tends to be readily formed. Further, when a compound containing a donor element is in the shape of solid particles, the particle size is more preferably 50 µm or less. Although there is no particular restriction on the lower limit, it is preferably 0.01 µm or more, more preferably 0.1 µm or more. When the compound containing a donor element is in the form of solid particles, the particle size of a particle refers to a volume average particle diameter, which can be measured by a laser scattering diffraction particle size distribution analyzer and the like. The volume average particle diameter can be measured by detecting a relationship between a scattered light intensity and an angle of a laser beam by which a particle is irradiated, and calculating based on the Mie scattering theory. Although there is no particular restriction on a dispersion medium to be used for the measurement, a dispersion medium in which particles to be measured are not dissolved is preferred. Further, in a case of particles that do not form a secondary aggregation, it is also possible to calculate by measuring the average particle diameter with a scanning electron microscope.

In a case of a composition for forming an n-type diffusion layer in which the compound containing a donor element is dissolved in a dispersion medium, there is no particular restriction on the shape of a compound containing a donor element that is to be used for preparation of the composition for forming an n-type diffusion layer.

The content of the compound containing a donor element in the composition for forming an n-type diffusion layer is determined in view of application suitability of the composition for forming an n-type diffusion layer, diffusibility of a donor element, and the like. In general, the content of the compound containing a donor element in the composition for forming an n-type diffusion layer is preferably from 0.1 mass% to 95 mass%, more preferably from 1 mass% to 90 mass%, further preferably from 1 mass% to 80 mass%, still further preferably from 2 mass% to 80 mass%, and especially preferably from 5 mass% to 20 mass%, in the composition for forming an n-type diffusion layer. When the content of the compound containing a donor element is 0.1 mass% or more, an n-type diffusion layer can be formed sufficiently. When the content of the compound containing a donor element is 95 mass% or less, dispersibility of the compound containing a donor element in a composition for forming an n-type diffusion layer becomes favorable, and application suitability with respect to a semiconductor substrate is improved.

The compound containing a donor element is preferably glass particles containing a donor element. The glass refers to a substance in which a clear crystalline state is not recognized in its atomic order in an X-ray diffraction spectrum, and has an irregular network structure and exhibits a glass transition phenomenon. By using glass particles containing a donor element, diffusion of a donor element out from a region at which the composition for forming an n-type diffusion layer has been applied (also referred to as "out-diffusion") tends to be suppressed more effectively, and formation of an unnecessary n-type diffusion layer at a back side and side surfaces can be suppressed. In other words, by using glass particles containing a donor element, an n-type diffusion layer can be formed in a more selective manner.

The glass particles containing a donor element will be described in detail. In the present invention, the glass particles contained in the composition for forming an n-type diffusion layer melt at a temperature during thermal diffusion (approximately from 800°C to 2000°C) and form a glass layer over an n-type diffusion layer. As a result, the out-diffusion can be further suppressed. After formation of the n-type diffusion layer, the glass layer formed on the n-type diffusion layer can be removed by performing etching (for example, with a hydrofluoric acid aqueous solution).

The glass particles containing a donor element can be formed by, for example, including a substance containing a donor element and a glass component substance. As a substance containing a donor element used for introducing a donor element into glass particles, a compound containing P (phosphorus) is preferable, and at least one selected from the group consisting of P₂O₃ and P₂O₅ is more preferable.

There is no particular restriction on the content of a substance containing a donor element in the glass particles containing a donor element. For example, from a viewpoint of diffusibility of a donor element, the content of the substance containing a donor element is preferably from 0.5 mass% to 100 mass%, more preferably from 2 mass% to 80 mass%. Further, from a viewpoint of diffusibility of a donor element, the glass particles containing a donor element preferably contains, as a substance containing a donor element, at least one selected from the group consisting of P₂O₃ and P₂O₅ in an amount from 0.01 mass% to 100 mass%, more preferably from 0.01 mass% to 10 mass%, further preferably from 2 mass% to 10 mass%.

As necessary, the melting temperature, softening temperature, glass transition temperature, chemical resistance, and the like of the glass particles containing a donor element can be regulated by adjusting the content ratio of the components. Further, the glass particles containing a donor element preferably include at least one of the following glass component substances.

Examples of the glass component substance include SiO₂, K₂O, Na₂O, Li₂O, BaO, SrO, CaO, MgO, BeO, ZnO, PbO, CdO, V₂O₅, SnO, WO₃, MoO₃, MnO, La₂O₃, Nb₂O₅, Ta₂O₅, Y₂O₃, CsO₂, TiO₂, ZrO₂, GeO₂, TeO₂, and Lu₂O₃. Among these, at least one selected from the group consisting of SiO₂, K₂O, Na₂O, Li₂O, BaO, SrO, CaO, MgO, BeO, ZnO, PbO, CdO, V₂O₅, SnO, ZrO₂, MoO₃, GeO₂, Y₂O₃, CsO₂ and TiO₂ is preferably used, and at least one selected from the group consisting of SiO₂, K₂O, Na₂O, Li₂O, BaO, SrO, CaO, MgO, BeO, ZnO, PbO, CdO, V₂O₅, SnO, ZrO₂ and MoO₃ is more preferably used.

Specific examples of the glass particles containing a donor element include a system containing both the substance containing a donor element and the glass component substance. More specifically, the examples include glass particles of systems containing P₂O₅ as a substance containing a donor element, such as a P₂O₅-SiO₂ system (described in the order of substance containing a donor element - glass component substance, hereinafter the same shall apply), a P₂O₅-K₂O system, a P₂O₅-Na₂O system, a P₂O₅-Li₂O system, a P₂O₅-BaO system, a P₂O₅-SrO system, a P₂O₅-CaO system, a P₂O₅-MgO system, a P₂O₅-BeO system, a P₂O₅-ZnO system, a P₂O₅-CdO system, a P₂O₅-PbO system, a P₂O₅-V₂O₅ system, a P₂O₅-SnO system, a P₂O₅-GeO₂ system, and a P₂O₅-TeO₂ system, and glass particles of these systems containing P₂O₃ instead of P₂O₅. The glass particles may contain two or more kinds of substances containing a donor element, such as a P₂O₅-Sb₂O₃ system and a P₂O₅-As₂O₃ system.

Although examples of a composite glass including two components are listed above, glass particles including a substance with three or more components, such as P₂O₅-SiO₂-V₂O₅ and P₂O₅-SiO₂-CaO, may be used.

Preferably, the glass particles include at least one substance containing a donor element selected from the group consisting of P₂O₃ and P₂O₅, and at least one glass component substance selected from the group consisting of SiO₂, K₂O, Na₂O, Li₂O, BaO, SrO, CaO, MgO, BeO, ZnO, PbO, CdO, V₂O₅, SnO, ZrO₂, MoO₃, GeO₂, Y₂O₃, CsO₂ and TiO₂. More preferably, the glass particles include at least one substance containing a donor element selected from the group consisting of P₂O₃ and P₂O₅, and at least one glass component substance selected from the group consisting of SiO₂, K₂O, Na₂O, Li₂O, BaO, SrO, CaO, MgO, BeO, ZnO, PbO, CdO, V₂O₅, SnO, ZrO₂ and MoO₃. Further preferably, the glass particles include P₂O₅ as a substance containing a donor element, and at least one glass component substance selected from the group consisting of SiO₂, ZnO, CaO, Na₂O, Li₂O and BaO. Use of glass particles as mentioned above enables a further lowering in a sheet resistance of a n-type diffusion layer to be formed.

The content of the glass component substance selected from the group consisting of SiO₂ and GeO₂ (hereinafter, also referred to as a "specific glass component substance") in the glass particles is preferably determined in view of the melting temperature, softening point, glass transition point, and chemical resistance. In general, the content of a specific glass component substance in 100 mass% of the glass particles is preferably from 0.01 mass% to 80 mass%, more preferably from 0.1 mass% to 50 mass%. When the content of the specific glass component substance is 0.01 mass% or more, an n-type diffusion layer can be efficiently formed. When the content of the specific glass component substance is 80 mass% or less, formation of an n-type diffusion layer at a region to which a composition for forming an n-type diffusion layer has not ben applied can be effectively suppressed.

The glass particles may include a network modifying oxide (for example, an alkali oxide or an alkaline-earth oxide) or an intermediate oxide that does not vitrify alone, in addition to the specific glass component substance. Specifically, in a case of P₂O₅-SiO₂-CaO glass, the content of CaO as a network modifying oxide is preferably from 1 mass% to 30 mass%, more preferably from 5 mass% to 20 mass%.

The softening point of the glass particles is preferably from 200°C to 1000°C from viewpoints of diffusibility and dripping during a thermal treatment, more preferably from 300°C to 900°C. The softening point of the glass particles can be determined from a differential thermal analysis (DTA) curve obtained with a simultaneous thermogravimetry/differential thermal analysis apparatus. Specifically, a third peak from the low temperature side of a DTA curve can be defined as a softening point.

The glass particles including a donor element can be produced according to the following procedures.

First, the source materials, for example, a substance containing a donor element and a glass component substance are weighed and placed in a crucible. Examples of the material of the crucible include platinum, platinum-rhodium, iridium, alumina, quartz and carbon, which is selected appropriately in view of the melting temperature, atmosphere, reactivity with a molten substance, and the like. Next, the source materials are heated at a temperature that is determined according to the glass composition in an electrical oven, thereby obtaining a melt. During heating, the source materials are preferably stirred such that a uniform melt is obtained. Then, the obtained melt is cast over a zirconia substrate, a carbon substrate, or the like, and vitrified. Finally, the glass is pulverized into a powder. The pulverization may be performed by a known method, such as jet milling, bead milling, and ball milling.

### (Dispersion medium)

The composition for forming an n-type diffusion layer according to the invention includes a dispersion medium.

A dispersion medium refers to a medium that disperses or dissolves the compound containing a donor element and the organic filler in a composition. Specifically, the dispersion medium preferably includes at least a solvent or water. The dispersion medium may include an organic binder as described below, in addition to the solvent or water.

Examples of a solvent include a ketone solvent, such as acetone, methyl ethyl ketone, methyl n-propyl ketone, methyl isopropyl ketone, methyl n-butyl ketone, methyl isobutyl ketone, methyl n-pentyl ketone, methyl n-hexyl ketone, diethyl ketone, dipropyl ketone, diisobutyl ketone, trimethylnonanone, cyclohexanone, cyclopentanone, methylcyclohexanone, 2,4-pentanedione, and acetonylacetone; an ether solvent, such as diethyl ether, methyl ethyl ether, methyl n-propyl ether, diisopropyl ether, tetrahydrofuran, methyltetrahydrofuran, dioxane, dimethyldioxane, ethylene glycol dimethyl ether, ethylene glycol diethyl ether, ethylene glycol di n-propyl ether, ethylene glycol dibutyl ether, diethylene glycol dimethyl ether, diethylene glycol diethyl ether, diethylene glycol methyl ethyl ether, diethylene glycol methyl-n-propyl ether, diethylene glycol methyl n-butyl ether, diethylene glycol di-n-propyl ether, diethylene glycol di-n-butyl ether, diethylene glycol methyl n-hexylether, triethylene glycol dimethyl ether, triethylene glycol diethyl ether, triethylene glycol methyl ethyl ether, triethylene glycol methyl-n-butyl ether, triethylene glycol di-n-butyl ether, triethylene glycol methyl-n-hexyl ether, tetraethylene glycol dimethyl ether, tetraethylene glycol diethyl ether, tetraethylene glycol methyl ethyl ether, tetraethylene glycol methyl-n-butyl ether, tetraethylene glycol di-n-butyl ether, tetraethylene glycol methyl n-hexyl ether, tetraethylene glycol di-n-butyl ether, propylene glycol dimethyl ether, propylene glycol diethyl ether, propylene glycol di-n-propyl ether, propylene glycol dibutyl ether, dipropylene glycol dimethyl ether, dipropylene glycol diethyl ether, dipropylene glycol methyl ethyl ether, dipropylene glycol methyl-n-butyl ether, dipropylene glycol di-n-propyl ether, dipropylene glycol di-n-butyl ether, dipropylene glycol methyl-n-hexylether, tripropylene glycol dimethyl ether, tripropylene glycol diethyl ether, tripropylene glycol methyl ethyl ether, tripropylene glycol methyl-n-butyl ether, tripropylene glycol di-n-butyl ether, tripropylene glycol methyl-n-hexyl ether, tetrapropylene glycol dimethyl ether, tetrapropylene glycol diethyl ether, tetradipropylene glycol methyl ethyl ether, tetrapropylene glycol methyl n-butyl ether, tetrapropylene glycol di-n-butyl ether, tetrapropylene glycol methyl n-hexyl ether, and tetrapropylene glycol di-n-butyl ether; an ester solvent, such as methyl acetate, ethyl acetate, n-propyl acetate, isopropyl acetate, n-butyl acetate, isobutyl acetate, 2-butyl acetate, n-pentyl acetate, sec-pentyl acetate, 3-methoxybutyl acetate, methylpentyl acetate, 2-ethylbutyl acetate, 2-ethylhexyl acetate, 2-(2-butoxyethoxy)ethyl acetate, benzyl acetate, cyclohexyl acetate, methylcyclohexyl acetate, nonyl acetate, methyl acetoacetate, ethyl acetoacetate, diethylene glycol methyl ether acetate, diethylene glycol monoethyl ether acetate, dipropylene glycol methyl ether acetate, dipropylene glycol ethyl ether acetate, glycol diacetate, methoxytriglycol acetate, ethyl propionate, n-butyl propionate, isoamyl propionate, diethyl oxalate, di-n-butyl oxalate, methyl lactate, ethyl lactate, n-butyl lactate, n-amyl lactate, ethylene glycol methyl ether propionate, ethylene glycol ethyl ether propionate, ethylene glycol methyl ether acetate, ethylene glycol ethyl ether acetate, propylene glycol methyl ether acetate, propylene glycol ethyl ether acetate, propylene glycol propyl ether acetate, γ-butyrolactone, and γ-valerolactone; an aprotic polar solvent, such as acetonitrile, N-methylpyrrolidinone, N-ethylpyrrolidinone, N-propylpyrrolidinone, N-butylpyrrolidinone, N-hexylpyrrolidinone, N-cyclohexylpyrrolidinone, N,N-dimethylformamide, N,N-dimethylacetamide, and dimethyl sulfoxide; an alcohol solvent, such as methanol, ethanol, n-propanol, isopropanol, n-butanol, isobutanol, 2-butanol, t-butanol, n-pentanol, isopentanol, 2-methylbutanol, 2-pentanol, t-pentanol, 3-methoxybutanol, n-hexanol, 2-methylpentanol, 2-hexanol, 2-ethylbutanol, 2-heptanol, n-octanol, 2-ethylhexanol, 2-octanol, n-nonyl alcohol, n-decanol, 2-undecyl alcohol, trimethylnonyl alcohol, 2-tetradecyl alcohol, 2-heptadecyl alcohol, phenol, cyclohexanol, methylcyclohexanol, benzyl alcohol, ethylene glycol, 1,2-propylene glycol, 1,3-butylene glycol, diethylene glycol, dipropylene glycol, triethylene glycol, tripropylene glycol, and isobornyl cyclohexanol; a glycol monoether solvent, such as ethylene glycol monomethyl ether, ethylene glycol monoethyl ether, ethylene glycol monophenyl ether, diethylene glycol monomethyl ether, diethylene glycol monoethyl ether, diethylene glycol mono-n-butyl ether, diethylene glycol mono-n-hexyl ether, ethoxytriglycol, tetraethylene glycol mono-n-butyl ether, propylene glycol monomethyl ether, dipropylene glycol monomethyl ether, dipropylene glycol monoethyl ether, and tripropylene glycol monomethyl ether; a terpene solvent including terpinene such as α-terpinene, terpineol such as α-terpineol, myrcene, allo-ocimene, limonene, dipentene, pinene such as α-pinene and β-pinene, carvone, ocimene, and phellandrene; and water. The solvent may be used singly or in a combination of two or more kinds thereof.

From the viewpoint of application suitability of the composition for forming an n-type diffusion layer to a semiconductor substrate, the solvent preferably includes at least one selected from the group consisting of an ester solvent, a glycol monoether solvent and a terpene solvent, more preferably at least one selected from the group consisting of 2-(2-butoxyethoxy)ethyl acetate, diethylene glycol mono-n-butyl ether, and α-terpineol.

The content of the dispersion medium in the composition for forming an n-type diffusion layer is determined in view of application suitability and the concentration of a donor element. For example, the content of the dispersion medium in the composition for forming an n-type diffusion layer is preferably from 5 mass% to 99 mass%, more preferably from 20 mass% to 95 mass%, further preferably from 40 mass% to 90 mass%. When the dispersion medium includes an organic binder, the total amount of the organic binder and the solvent or water is preferably within the above range.

### (Organic Filler)

The composition for forming an n-type diffusion layer according to the invention includes an organic filler. The organic filler refers to an organic compound in the form of particles or fibers. Since the composition for forming an n-type diffusion layer according to the invention includes an organic filler, it is possible to apply the composition for forming an n-type diffusion layer onto a semiconductor substrate into a shape of a fine line pattern of a desired size. In other words, because of the presence of an organic filler, expansion of a fine line pattern can be prevented. This is presumably because the organic filler imparts an appropriate thixotropy to the composition for forming an n-type diffusion layer. Further, by including the organic filler, an n-type diffusion layer can be formed into a desired shape without inhibiting diffusion of a donor element into a semiconductor substrate. In a case in which an inorganic filler is used instead of an organic filler, the filler does not disappear during thermal diffusion and remains. As a result, a glass layer formed from a molten glass particles tends to become ununiform and prevent diffusion of a donor element into a semiconductor substrate tends to be inhibited.

Examples of an organic compound that forms an organic filler include a urea formaldehyde resin, a phenol resin, a polycarbonate resin, a melamine resin, an epoxy resin, an unsaturated polyester resin, a silicone resin, a polyurethane resin, a polyolefin resin, an acrylic resin, a fluorocarbon resin, a polystyrene resin, cellulose, a formaldehyde resin, a coumarone-indene resin, lignin, a petroleum resin, an amino resin, a polyester resin, a polyether sulfone resin, a butadiene resin, and copolymers thereof. The organic compound may be used singly or in a combination of two or more kinds thereof.

Among these, as an organic compound that forms an organic filler, a compound that degrades at 700°C or less is preferable. When an organic compound that forms an organic filler degrades at 700°C or less, remaining of the organic filler or its thermal-treated product without disappearing after formation of an n-type diffusion layer can be prevented. If the organic filler remains, it may cause deterioration of the electricity generation performance of a photovoltaic cell. An organic filler that degrades at 400°C or less is preferred, and an organic filler that degrades at 300°C or less is more preferred. Although there is no particular restriction on the lower limit to the degradation temperature of an organic filler, it is preferably 150°C or more from a viewpoint of handleability at the application process, more preferably 200°C or more. The degradation temperature of an organic filler refers to a temperature at which the organic filler degrades and disappears, and can be measured by a thermogravimetric analyzer (DTG-60H, by Shimadzu Corporation). When the composition for forming an n-type diffusion layer, in which a dispersion medium that disappears at a degradation temperature of an organic filler or lower, is heated to the degradation temperature of an organic filler or higher, the dispersion medium and the organic filler disappear, whereby only the compound containing a donor element such as glass particles remains.

As an organic compound that forms an organic filler, at least one selected from the group consisting of an acrylic resin, a cellulose resin and a polystyrene resin is preferable from a viewpoint of thermal degradability, and an acrylic resin is more preferable.

Examples of a monomer that constitutes the acrylic resin include methyl acrylate, methyl methacrylate, ethyl acrylate, ethyl methacrylate, n-propyl acrylate, n-propyl methacrylate, isopropyl acrylate, isopropyl methacrylate, n-butyl acrylate, n-butyl methacrylate, isobutyl acrylate, isobutyl methacrylate, 2-butyl acrylate, 2-butyl methacrylate, tert-butyl acrylate, tert-butyl methacrylate, pentyl acrylate, pentyl methacrylate, hexyl acrylate, hexyl methacrylate, heptyl acrylate, heptyl methacrylate, 2-ethylhexyl acrylate, 2-ethylhexyl methacrylate, octyl acrylate, octyl methacrylate, nonyl acrylate, nonyl methacrylate, decyl acrylate, decyl methacrylate, dodecyl acrylate, dodecyl methacrylate, tetradecyl acrylate, tetradecyl methacrylate, hexadecyl acrylate, hexadecyl methacrylate, octadecyl acrylate, octadecyl methacrylate, eicosyl acrylate, eicosyl methacrylate, dococyl acrylate, dococyl methacrylate, cyclopentyl acrylate, cyclopentyl methacrylate, cyclohexyl acrylate, cyclohexyl methacrylate, cycloheptyl acrylate, cycloheptyl methacrylate, benzyl acrylate, benzyl methacrylate, phenyl acrylate, phenyl methacrylate, methoxyethyl acrylate, methoxyethyl methacrylate, dimethylaminoethyl acrylate, dimethylaminoethyl methacrylate, diethylaminoethyl acrylate, diethylaminoethyl methacrylate, dimethylaminopropyl acrylate, dimethylaminopropyl methacrylate, 2-chloroethyl acrylate, 2-chloroethyl methacrylate, 2-fluoroethyl acrylate, 2-fluoroethyl methacrylate, styrene, α-methylstyrene, cyclohexylmaleimide, dicyclopentanyl acrylate, dicyclopentanyl methacrylate, vinyltoluene, vinyl chloride, vinyl acetate, N-vinylpyrrolidone, butadiene, isoprene, and chloroprene. The monomers may be used singly or in a combination of two or more kinds thereof.

When the organic filler is in the form of particles, the average particle size is preferably 10 µm or less, more preferably 1 µm or less, further preferably 0.1 µm or less. When the average particle size of the organic filler is 10 µm or less, occurrence of precipitation in the composition for forming an n-type diffusion layer tends to be suppressed. Further, in a case in which the composition for forming an n-type diffusion layer is applied to a semiconductor substrate by a screen printing method, a factor that causes clogging of meshes of a printing mask can be removed. The average particle size of the organic filler can be measured by a particle size distribution analyzer based on a laser diffraction scattering method (LS13320, by Beckman Coulter, Inc.) and a median diameter calculated from the obtained particle size distribution may be defined as the average particle size. Alternatively, the average particle size may be determined through observation with a SEM (scanning electron microscope).

When the organic filler is in the form of fibers, the organic filler may be used without particular restriction, insofar as the object of the invention can be achieved.

There is no particular restriction on the molecular weight of an organic compound to be used as the organic filler, and is preferably adjusted appropriately in view of a desired viscosity of the composition for forming an n-type diffusion layer. The content of the organic filler in the composition for forming an n-type diffusion layer is preferably from 1 mass% to 50 mass%.

In the composition for forming an n-type diffusion layer, the mass ratio of the compound containing a donor element to the organic filler (compound containing a donor element : organic filler) is preferably from 1:50 to 50:1, more preferably from 1:10 to 10:1, further preferably from 1:5 to 5:1.

As necessary, the composition for forming an n-type diffusion layer according to the invention may include an organic binder, a surfactant, an inorganic powder, a resin containing a silicon atom, a deducing compound and the like, in addition to the compound containing a donor element, the organic filler, and the dispersion medium.

The composition for forming an n-type diffusion layer preferably further includes at least one organic binder. By including an organic binder, the viscosity of the composition for forming an n-type diffusion layer can be adjusted or thixotropy can be imparted, whereby the application suitability with respect to a semiconductor substrate can be improved. The organic binder can be selected appropriately from polyvinyl alcohol; a polyacrylamide resin; a polyvinylamide resin; a polyvinylpyrrolidone resin; a poly(ethylene oxide) resin; a polysulfone resin; an acrylamide alkylsulfonic acid resin; a cellulose derivative, such as cellulose ether, carboxy methyl cellulose, hydroxy ethyl cellulose, and ethyl cellulose; gelatin and a gelatin derivative; starch and a starch derivative; sodium alginate and a sodium alginate derivative; xanthan and a xanthan derivative; guar and a guar derivative; scleroglucan and a scleroglucan derivative; tragacanth and a tragacanth derivative; dextrin and a dextrin derivative; a (meth)acrylic acid resin; a (meth)acrylate resin, such as an alkyl (meth)acrylate resin, and a dimethylaminoethyl (meth)acrylate resin; a butadiene resin; a styrenic resin; and copolymers thereof. The organic binder may be used singly or in a combination of two or more kinds thereof. When the organic binder is used, at least one selected from the group consisting of a cellulose derivative, an acrylic resin derivative, and a poly(ethylene oxide) resin is preferred in view of degradability and handleability.

The molecular weight of the organic binder is not particularly restricted, and is preferably adjusted appropriately in view of a desired viscosity of the composition for forming an n-type diffusion layer. Further, when the composition for forming an n-type diffusion layer includes an organic binder, the content thereof in the composition for forming an n-type diffusion layer is preferably from 0.5 mass% to 30 mass%, more preferably from 3 mass% to 25 mass%, further preferably from 3 mass% to 20 mass%.

Examples of a surfactant include a nonionic surfactant, a cationic surfactant, and an anionic surfactant. Among them, a nonionic surfactant or a cationic surfactant is preferable and a nonionic surfactant is more preferable, because the amount of impurity such as a heavy metal that may be introduced is smaller. Examples of the nonionic surfactant include a silicon surfactant, a fluorine surfactant, and a hydrocarbon surfactant. Among these, a hydrocarbon surfactant, which disappears rapidly during heating for diffusion or the like, is preferred.

Examples of the hydrocarbon surfactant include a block copolymer of ethylene oxide and propylene oxide, and an acetylene glycol compound. From a viewpoint of more suppressing variation in the sheet resistance of a semiconductor substrate, an acetylene glycol compound is preferable.

As an inorganic powder, a substance that can function as a filler is preferable. Examples of an inorganic powder include silicon oxide, titanium oxide, silicon nitride, and silicon carbide.

Examples of a resin containing a silicon atom include a silicone resin.

Examples of a reducing compound include a polyalkylene glycol such as polyethylene glycol and polypropylene glycol, and a terminally alkylated polyalkylene glycol; a monosaccharide such as glucose, fructose and galactose, and a derivative of a monosaccharide; a disaccharide such as sucrose and maltose, and a derivative of a disaccharide; and a polysaccharide and a derivative of a polysaccharide. Among the reducing compounds, a polyalkylene glycol is preferable, and polypropylene glycol is further preferable. Addition of a reducing compound to the composition for forming an n-type diffusion layer may facilitate diffusion of a donor element into a semiconductor substrate.

There is no particular restriction on the method for producing the composition for forming an n-type diffusion layer. For example, the composition can be produced by mixing a compound containing a donor element, an organic filler, an dispersion medium, and other components if necessary, with a blender, a mixer, a mortar or a rotor. The mixing may be performed while heating, as desired. In a case of heating during mixing, the temperature may be between 30°C and 100°C, for example.

The components in the composition for forming an n-type diffusion layer and the content of the components can be identified by way of thermal analysis such as TG/DTA, NMR, HPLC, GEL permeation chromatography, GC-MS, IR, MALDI-MS and the like.

The viscoelasticity as a shear viscosity at 25°C at a shear rate of 0.01/sec of the composition for forming an n-type diffusion layer is preferably from 50 Pa·s to 10000 Pa·s, more preferably from 300 Pa·s to 7000 Pa·s, further preferably from 1000 Pa·s to 5000 Pa·s, in view of application suitability of the composition for forming an n-type diffusion layer.

A thixotropic characteristic of the composition for forming an n-type diffusion layer (hereinafter, referred to as "thixotropy") can be represented by a TI value, which is defined as [log₁₀(η^{0.01})-log₁₀(η¹⁰)], wherein the logarithm of a shear viscosity η^{x} at 25°C and at a shear rate of x[s⁻¹] is expressed as log₁₀(η^{x}). The TI value is preferably from 0.5 to 6.0, more preferably from 0.5 to 4.0, further preferably from 0.5 to 3.0. The shear viscosity can be measured with a viscoelasticity measuring apparatus (Rheometer MCR301, made by Anton Paar GmbH).

### <Method for producing semiconductor substrate having n-type diffusion layer>

The method for producing a semiconductor substrate having an n-type diffusion layer according to the invention includes a process of applying the composition for forming an n-type diffusion layer according to the invention onto at least a part of a semiconductor substrate; and a process of forming an n-type diffusion layer in the semiconductor substrate by performing a heat treatment.

There is no particular restriction on the method for applying a composition for forming an n-type diffusion layer according to the invention onto a semiconductor substrate, and the method may be selected from a printing method, a spin coating method, a brushing method, a spraying method, a doctor blade method, a roll coater method, an ink jet method, and the like, in view of the application.

In the method of producing a semiconductor substrate having an n-type diffusion layer according to the invention, there is no particular restriction on the method for performing a thermal treatment to the composition for forming an n-type diffusion layer that has been applied onto a semiconductor substrate. For example, the thermal treatment temperature may be between 600°C and 1200°C, and the thermal treatment time may be between 1 minute and 60 minutes. There is no particular restriction on an apparatus for performing the thermal treatment, and it may be a known continuous furnace, a batch furnace, or the like.

### <Method for producing photovoltaic cell element>

The method for producing a photovoltaic cell element according to the invention includes a process of applying the composition for forming an n-type diffusion layer according to the invention onto at least a part of a semiconductor substrate; a process of forming an n-type diffusion layer in the semiconductor substrate by performing a thermal treatment; and a process of forming an electrode on the n-type diffusion layer.

Examples of a method for forming an electrode on an n-type diffusion layer include a method in which a metal paste for forming an electrode that contains an electrode material is applied onto a desired region of a semiconductor substrate, dried as necessary, and then thermally treated; a method in which plating is performed with an electrode material to form an electrode; and a method in which an electrode material is deposited in a high vacuum by electron beam heating to form an electrode. Examples of a method for applying a metal paste for forming an electrode to a semiconductor substrate include a printing method, a spin coating method, a brushing method, a spraying method, a doctor blade method, a roll coater method, and an ink jet method. There is no particular restriction on the composition of a metal paste for an electrode. For example, the metal paste may include metal particles and glass particles as essential components, and if necessary, a resin binder or other additives.

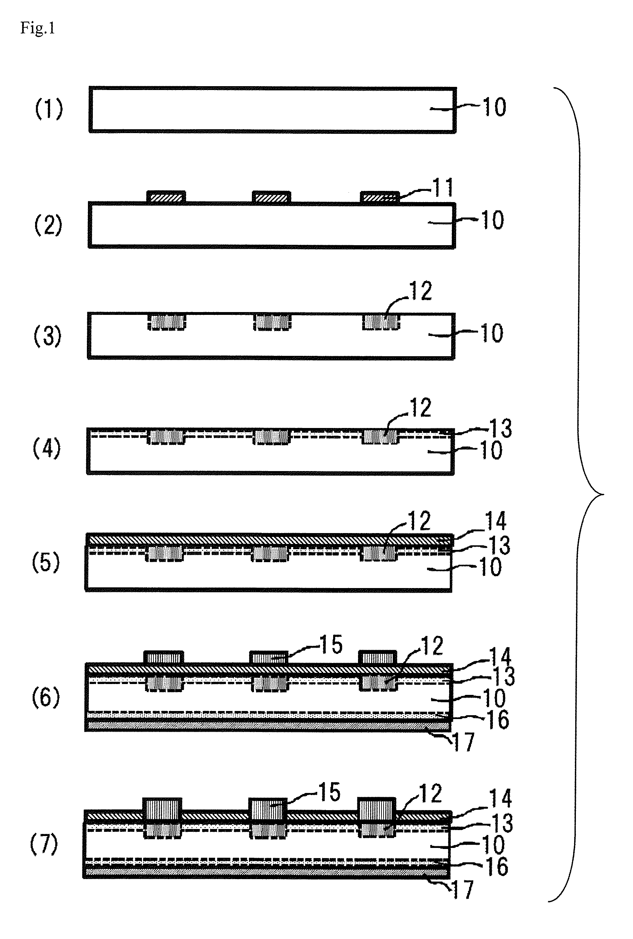

Next, the method for producing a semiconductor substrate having an n-type diffusion layer and a photovoltaic cell element according to the invention will be described by referring to the drawings. Figure 1 is a conceptual schematic cross-sectional view showing an example of processes for producing a photovoltaic cell element having a selective emitter structure according to the present embodiment. In the drawings, the same components are indicated by the same reference number.

First, a p-type semiconductor substrate 10 shown in Figure 1 (1) is prepared. The p-type semiconductor substrate 10 is provided with a textured structure at a surface that serves as a light receiving surface when assembled to a photovoltaic cell element. More specifically, a damaged layer on a surface of a p-type semiconductor substrate 10, which is formed upon slicing off from an ingot, is removed with 20 mass% caustic soda. Next, etching is performed with a mixture liquid of 1 mass% caustic soda and 10 mass% isopropyl alcohol, thereby forming a textured structure (not shown in the drawing). By forming a textured structure at a light receiving surface (top surface), a light trapping effect is promoted and a high efficiency is achieved.

Next, as shown in Figure 1 (2), on the top surface of the p-type semiconductor substrate 10, i.e., a surface that serves as a light receiving surface of a photovoltaic cell element, a composition for forming an n-type diffusion layer 11 is applied into a shape of fine line. There is no particular restriction on the method for applying the composition for forming an n-type diffusion layer 11 according to the invention, and examples of the method include a printing method, a spin coating method, a brushing method, a spraying method, a doctor blade method, a roll coater method, and an ink jet method. The application amount of the composition for forming an n-type diffusion layer 11 is preferably from 0.01 g/m² to 100 g/m², more preferably from 0.1 g/m² to 10 g/m².

Expansion of the line width of a fine line formed by applying the composition for forming an n-type diffusion layer 11 is preferably within 100 µm from a predetermined value, more preferably within 35 µm, further preferably within 10 µm, and still further preferably within 5 µm.

For example, when the composition for forming an n-type diffusion layer 11 is applied onto a semiconductor substrate into a line having a width of 150 µm, the width of the composition for forming an n-type diffusion layer 11 as measured after drying is preferably 250 µm or less, more preferably 185 µm or less, further preferably 160 µm or less, still further preferably 155 µm or less.

The expansion rate of the line width of a fine line formed by applying the composition for forming an n-type diffusion layer 11 is preferably within 67% of a predetermined value, more preferably within 25%, further preferably within 5%.

In a case in which the composition for forming an n-type diffusion layer includes a solvent, a drying process may be necessary in order to evaporate the solvent in the composition for forming an n-type diffusion layer that has been applied onto a semiconductor substrate. For example, the drying is performed at a temperature of approximately from 80°C to 300°C, for a time of from 1 minute to 10 minutes with a hot plate or from 10 minutes to 30 minutes with a drier. The drying conditions depend on the composition of a solvent contained in the applied composition for forming an n-type diffusion layer, and are not particularly restricted to the above conditions according to the invention.

Next, as shown in Figure 1 (3), the semiconductor substrate 10, to which the composition for forming an n-type diffusion layer 11 has been applied, is subjected to a thermal treatment. Although there is no particular restriction on the thermal treatment temperature, it is preferably from 600°C to 1200°C, more preferably from 750°C to 1050°C. Although there is no particular restriction on the thermal diffusion treatment time, it is preferably between 1 minute and 30 minutes. By performing the thermal treatment, a donor element diffuses into the semiconductor substrate and an n-type diffusion layer 12 is formed. The thermal treatment may be performed with a known device such as a continuous furnace, a batch-wise furnace or the like. Since a glass layer (not illustrated) such as phosphate glass is formed on a surface of the n-type diffusion layer 12, it is removed by performing etching. The etching may be performed by a known method such as a method of immersing in an acid like hydrofluoric acid or a method of immersing in an alkali like caustic soda.

Further, as shown in Figure 1 (4), at a region of the light receiving surface other than a portion at which the composition for forming an n-type diffusion layer 11 has been applied, an n-type diffusion layer 13 having a lower phosphorus concentration than the n-type diffusion layer 12 is formed. There is no particular restriction on a method of forming an n-type diffusion layer 13, and may be a gas phase reaction method in which a composition for forming an n-type diffusion layer having a lower content of a phosphorus compound, or phosphorus oxychloride is used, for example.

As shown in Figures 1 (2) and (3), according to the method of the invention in which an n-type diffusion layer 12 is formed with a composition for forming an n-type diffusion layer 11, an n-type diffusion layer 12 is formed only at a desired region of a semiconductor substrate, while not forming an unnecessary n-type diffusion layer at the back side or side surfaces. Consequently, the process can be simplified by omitting a side etching process for removing an unnecessary n-type diffusion layer, which has been an essential process in a method of forming an n-type diffusion layer by a conventional gas phase reaction method. Nevertheless, when an n-type diffusion layer 13 is formed by a gas phase reaction method, a side etching process needs to be performed.

As shown in Figure 1 (5), an antireflection film 14 may be formed on the n-type diffusion layer 12. An antireflection film 14 can be formed by a known technique. For example, in a case of forming a silicon nitride film as an antireflection film 14, the film may be formed by a plasma CVD method using a mixed gas of SiH₄ and NH₃ as a source material. In that case, hydrogen diffuses into a crystal and bonds with an orbit that does not contribute to a bond with a silicon atom, i.e., a dangling bond, whereby a defect is inactivated (hydrogen passivation). More specifically, the film is formed under the conditions of a flow rate ratio of a mixed gas NH₃/SiH₄ of from 0.05 to 1.0, the pressure in a reactor of from 13.3 Pa to 266.6 Pa (0.1 Torr to 2 Torr), the temperature at film formation of from 300°C to 550°C, and the frequency for plasma discharge of 100 kHz or more. Although there is no particular restriction on the film thickness of the antireflection film, it is preferably from 10 nm to 300 nm, more preferably from 30 nm to 150 nm.

Then, as shown in Figure 1 (6), a metal paste for a top surface electrode is applied by a screen printing method onto the antireflection film 14 formed at the top surface (light receiving surface) of a p-type semiconductor substrate, and dried to form a top surface electrode 15. Although there is no particular restriction on the composition of a metal paste for a top surface electrode, it may include metal particles and glass particles as essential components, and a resin binder or other additives as necessary.

Then, a p⁺-type diffusion layer (high concentration electric field layer) 16 and a back side electrode 17 are formed at the back side of the p-type semiconductor substrate 10. Generally, a layer of a metal paste for a back side electrode containing aluminum is formed at a back side electrode of the p-type semiconductor substrate 10, and the layer is sintered to form a back side electrode 17 and a p⁺-type diffusion layer 16 by diffusing aluminum into the back side of the p-type semiconductor substrate 10, at the same time. At this time, a silver paste for forming a silver electrode may be applied at a portion of the back side for forming a connection between devices at a module process step.

In a conventional production method, it is necessary to convert an n-type diffusion layer, which is formed by diffusion of phosphorus at the back side of a semiconductor substrate, to a p-type diffusion layer by using aluminum or the like. In this method, in order to achieve a sufficient conversion into a p-type diffusion layer and also forming a p⁺-type diffusion layer, a thick aluminum layer needs to be formed in order to secure a sufficient amount of aluminum. However, since the coefficient of thermal expansion of aluminum is significantly different from the coefficient of thermal expansion of silicon used as the substrate, a large internal stress is developed in the semiconductor substrate during the process of firing and cooling, which may cause warpage of the semiconductor substrate.

Therefore, there is a problem in that the internal stress may damage crystal grain boundaries of crystals, resulting in a large electric power loss. Further, warpage of a semiconductor substrate tends to cause breakage of a photovoltaic cell element during conveyance of a photovoltaic cell element or connecting the same with a copper line, referred to as a tab line, in a module process. Further, due to a recent improvement in slicing techniques, the thickness of a semiconductor substrate has been reducing and a photovoltaic cell element is becoming easier to crack.

In the production method according to the invention, since an unnecessary n-type diffusion layer is not formed on the back side of a semiconductor substrate, converting an n-type diffusion layer to a p-type diffusion layer need not be performed and an aluminum layer needs not to be thickened. As a result, development of an internal stress in a semiconductor substrate or warpage of a semiconductor substrate can be suppressed. Consequently, an increase in electric power loss or breakage of a photovoltaic cell element can be suppressed.

In the production method according to the invention, the method for forming a p⁺-type diffusion layer 16 at the back side is not limited to a method of using a metal paste for a back side electrode containing aluminum, and any conventional method may be employed from a wide range of choices. For example, a p⁺-type diffusion layer 16 can be formed by applying a composition for forming a p-type diffusion layer containing a group 13 element, such as boron, onto the back side of a semiconductor substrate.

In the production method according to the invention, the material for a back side electrode 17 is not limited to aluminum that belongs to group 13, and may be silver, copper or the like. It is also possible to reduce the thickness of a back side electrode 17 than a conventional electrode. There is no particular restriction on a material or a formation method for a back side electrode 17. For example, a back side electrode 17 may be formed by applying a paste for a back side electrode containing a metal such as aluminum, silver or copper onto the back side of a semiconductor substrate, and drying the same. In that case, a silver paste for forming a silver electrode may be applied also at a portion of the back side of a semiconductor substrate for forming a connection between photovoltaic cell elements in a module process.

In Figure 1 (7), the electrodes are sintered and a photovoltaic cell element is obtained. The temperature for the sintering may be, for example, in a range of from 600°C to 900°C, and the time may be, for example, several seconds to several minutes. In that case, at the top surface side of a semiconductor substrate, the antireflection film 14 provided as an insulation film is molten by means of glass particles in the metal paste for an electrode, and a part of the surface of a p-type semiconductor substrate 10 is also molten, whereby a contact is formed between metal particles (for example, silver particles) in the metal paste for an electrode solidifies and the semiconductor substrate 10. As a result, conduction between the top surface electrodes 15 and the semiconductor substrate 10, which is referred to as fire-through, is established.

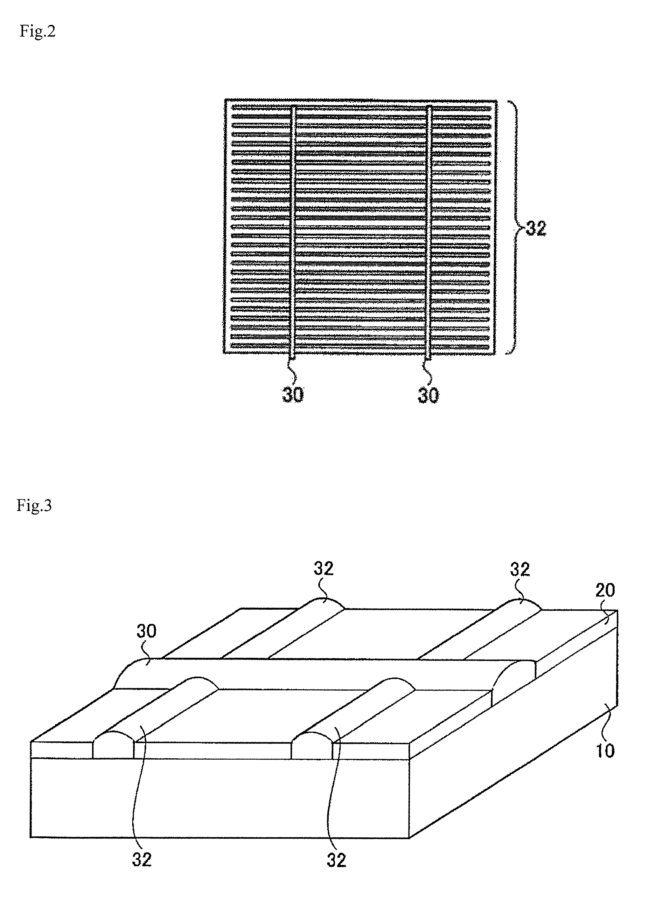

Examples of the configuration of a top surface electrode 15 include a configuration in which bus bar electrodes 30 are positioned across finger electrodes 32, as shown in Figure 2 and Figure 3. Figure 2 is a plan view of a photovoltaic cell element having top surface electrodes 15 formed of bus bar electrodes 30 and finger electrodes 32 intersecting with each other as viewed from the top surface. Figure 3 is an enlarged perspective view of a part of Figure 2, in which top surface electrodes 15 penetrate an antireflection layer 20 on the semiconductor substrate 10.

The top surface electrode 15 having a structure as mentioned above can be formed by, for example, applying a metal paste for an electrode by screen printing or the like, and performing a sintering treatment as described above. Alternatively, the electrode can be formed by plating an electrode material or depositing an electrode material in a high vacuum by electron beam heating, or the like. The top surface electrode 15 formed of bus bar electrodes 30 and finger electrodes 32 is commonly used as an electrode on the light receiving top surface side of a photovoltaic cell element, and a known method for forming a bus bar electrode and a finger electrode on the light receiving top surface side of a photovoltaic cell element can be applied.

In the exemplary embodiments above, a photovoltaic cell element has a structure in which an n-type diffusion layer is formed on the top surface of a semiconductor substrate and a p⁺-type diffusion layer is formed on the back side, and a top surface electrode and a back side electrode are provided on the respective layers. However, it is also possible to produce a back-contact type photovoltaic cell element by using the composition for forming an n-type diffusion layer according to the invention. A back-contact type photovoltaic cell element has all electrodes at the back side in order to increase the area of the light receiving surface. Namely, it is necessary to form both the n-type diffusion region and the p⁺-type diffusion region at the back side in order to form a pn-junction structure. Since the composition for forming an n-type diffusion layer according to the invention is capable of forming an n-type diffusion portion only at a desired portion, it is suitably used for the production of a back-contact type photovoltaic cell element. Although there is no particular restriction on the shape or the size of a photovoltaic cell element that is produced by the method for producing a photovoltaic cell element as described above, it is preferably a square having the size of from 125 mm to 156 mm at each side.

### <Photovoltaic cell>

The photovoltaic cell according to the invention includes one or more photovoltaic cell elements produced by the production method as mentioned above, and wiring materials that is positioned on the electrodes of the photovoltaic cell elements. As necessary, a photovoltaic cell may have a structure in which plural photovoltaic cell elements are connected with a wiring material and sealed with a sealing material. A photovoltaic cell element produced by the production method of a photovoltaic cell element can be used for producing a photovoltaic cell.

There is no particular restriction on the wiring material and the sealing material, and an appropriate material may be selected from materials that are commonly used in the industry. Although there is no particular restriction on the shape or the size of a photovoltaic cell, it is preferably from 0.5 m² to 3 m².

### Examples

In the following, examples of the invention are described more specifically. However, the invention is not limited to the examples. Unless otherwise specified, reagent chemicals were used for the chemicals. Unless otherwise specified, "%" means "% by mass".

### [Example 1]

A composition for forming an n-type diffusion layer in a paste form was prepared by mixing 1 g of a P₂O₅-SiO₂-CaO glass (P₂O₅: 50%, SiO₂: 43%, CaO: 7%) powder, 0.3 g of ethyl cellulose, 8.6 g of 2-(2-butoxyethoxy)ethyl acetate, 0.1 g of an organic filler (PMMA resin filler, MR grade, cross-linked particles, average particle size: 0.1 µm, degradation temperature: 400°C, manufactured by Soken Chemical Engineering Co., Ltd.) The shear viscosity of the composition for forming an n-type diffusion layer at 25°C was 500 Pa·s at a shear rate of 0.01/s, and 50 Pa·s at 10/s. The TI value was 1.00. The shear rate was measured at 25°C with a viscoelasticity measuring apparatus (Rheometer MCR301, manufactured by Anton Paar GmbH).

Next, the composition for forming an n-type diffusion layer was applied by screen printing onto a surface of a p-type silicon wafer (manufactured by PVG Solutions Inc.) in a shape of a fine line, and dried on a hot plate at 150°C for 1 minute. A screen printing plate designed for obtaining a 150 µm-wide fine line was used. The squeegee speed and the scraper speed were 300 mm/sec, respectively, and the application amount was 2.1 g/m². The width of the fine line was measured with a light microscope (manufactured by Olympus Corporation). The result was 180 µm, indicating that the expansion from the designed value was within 35 µm.

Next, a thermal treatment was performed in a tunnel furnace (horizontal tube diffusion furnace, ACCURON CQ-1200, made by Hitachi Kokusai Electric Inc.) with an air flow of 5 L/min at 900°C for 10 minutes. Thereafter, in order to remove a glass layer formed on a surface of the p-type silicon substrate, the substrate was immersed in a 2.5 mass% HF aqueous solution for 5 minutes, and then subjected to washing with running water, ultrasonic cleaning, and drying. A p-type silicon substrate on which an n-type diffusion layer was formed was thus obtained.

The sheet resistance at a surface of the side applied with the composition for forming an n-type diffusion layer was 40 Ω/□, and it was confirmed that an n-type diffusion layer was formed by diffusion of P (phosphorus). The sheet resistance at the back side was unmeasurable, namely 1000000 Ω/□ or more, and it was confirmed that an n-type diffusion layer was not formed. The sheet resistance was measured by a 4-pin probe method with a low resistivity meter (LORESTA-EP model MCP-T360, manufactured by Mitsubishi Chemical Corporation).

### [Example 2]

A composition for forming an n-type diffusion layer in a paste form was prepared in a similar manner to Example 1, except that 1 g of P₂O₅-SiO₂-CaO glass particles (P₂O₅: 50%, SiO₂: 43%, CaO: 7%), 0.3 g of ethyl cellulose, 6.7 g of 2-(2-butoxyethoxy)ethyl acetate, and 2 g of an organic filler (PMMA resin filler, MR grade, average particle size: 0.1 µm, manufactured by Soken Chemical Engineering Co., Ltd.) were used. The shear viscosity of the composition for forming an n-type diffusion layer was measured by a similar method to Example 1. The results were 5000 Pa·s at a shear rate of 0.01/s and 80 Pa·s at 10/s. The TI value was 1.80.

The composition for forming an n-type diffusion layer was applied onto the p-type silicon wafer surface and dried by a similar method to Example 1, and the line width was measured. The line width was 155 µm and the expansion from the designed width was within 5 µm. The application amount was 2.2 g/m².

The p-type silicon wafer after application of the composition for forming an n-type diffusion layer was subjected to a thermal treatment by a similar method to Example 1, and the sheet resistance was measured. The sheet resistance at a surface on the side applied with the composition for forming an n-type diffusion layer was 40 Ω/□, and it was confirmed that an n-type diffusion layer was formed by diffusion of phosphorus. The sheet resistance at the back side was unmeasurable, namely 1000000 Ω/□ or more, and it was confirmed that an n-type diffusion layer was not formed.

### [Example 3]

A composition for forming an n-type diffusion layer in a paste form was prepared in a similar manner to Example 1, except that an organic filler of the same kind having an average particles size of 5.0 µm was used instead of the organic filler having an average particle size of 0.1 µm. The shear viscosity of the composition for forming an n-type diffusion layer was measured by a similar method to Example 1. The results were 300 Pa·s at a shear rate of 0.01/s and 60 Pa·s at 10/s. The TI value was 0.70.

The composition for forming an n-type diffusion layer was applied onto the p-type silicon wafer surface and dried by a similar method to Example 1, and the line width was measured. The line width was 200 µm and the expansion from the designed width was within 50 µm. The application amount was 2.1 g/m².

The p-type silicon wafer after application of the composition for forming an n-type diffusion layer was subjected to a thermal treatment by a similar method to Example 1, and the sheet resistance was measured. The sheet resistance at a surface on the side applied with the composition for forming an n-type diffusion layer was 40 Ω/□, and it was confirmed that an n-type diffusion layer was formed by diffusion of phosphorus. The sheet resistance at the back side was unmeasurable, namely 1000000 Ω/□ or more, and it was confirmed that an n-type diffusion layer was not formed.

### [Example 4]

A composition for forming an n-type diffusion layer in a paste form was prepared in a similar manner to Example 1, except that 1 g of P₂O₅-SiO₂-CaO glass particles (P₂O₅: 50%, SiO₂: 43%, CaO: 7%), 8.3 g of 2-(2-butoxyethoxy)ethyl acetate, and 0.7 g of an organic filler (PMMA resin filler, MR grade, particle size: 0.1 µm, manufactured by Soken Chemical Engineering Co., Ltd.) were used. The shear viscosity of the composition for forming an n-type diffusion layer was measured by a similar method to Example 1. The results were 5000 Pa·s at a shear rate of 0.01/s and 80 Pa·s at 10/s. The TI value was 1.80.

The composition for forming an n-type diffusion layer was applied onto the p-type silicon wafer surface and dried by a similar method to Example 1, and the line width was measured. The line width was 155 µm and the expansion from the designed width was within 5 µm. The application amount was 2.2 g/m².

The p-type silicon wafer after application of the composition for forming an n-type diffusion layer was subjected to a thermal treatment by a similar method to Example 1, and the sheet resistance was measured. The sheet resistance at a surface on the side applied with the composition for forming an n-type diffusion layer was 40 Ω/□, and it was confirmed that an n-type diffusion layer was formed by diffusion of phosphorus. The sheet resistance at the back side was unmeasurable, namely 1000000 Ω/□ or more, and it was confirmed that an n-type diffusion layer was not formed.

### [Example 5]

A composition for forming an n-type diffusion layer in a paste form was prepared in a similar manner to Example 1, except that 1 g of P₂O₅-SiO₂-CaO glass particles, 0.29 g of ethyl cellulose, 8.7 g of 2-(2-butoxyethoxy)ethyl acetate, and 0.01 g of an organic filler (PMMA resin filler, MR grade, average particle size: 0.1 µm, manufactured by Soken Chemical Engineering Co., Ltd.) were used. The shear viscosity of the composition for forming an n-type diffusion layer was measured by a similar method to Example 1. The results were 260 Pa·s at a shear rate of 0.01/s and 80 Pa·s at 10/s. The TI value was 0.51.

The composition for forming an n-type diffusion layer was applied onto the p-type silicon wafer surface and dried by a similar method to Example 1, and line width was measured. The line width was 220 µm and the expansion from the designed width was 70 µm. The application amount was 2.3 g/m².

The p-type silicon wafer after application of the composition for forming an n-type diffusion layer was subjected to a thermal treatment by a similar method to Example 1, and the sheet resistance was measured. The sheet resistance at a surface on the side applied with the composition for forming an n-type diffusion layer was 40 Ω/□, and it was confirmed that an n-type diffusion layer was formed by diffusion of phosphorus. The sheet resistance at the back side was unmeasurable, namely 1000000 Ω/□ or more, and it was confirmed that an n-type diffusion layer was not formed.

### [Comparative Example 1]

A composition for forming an n-type diffusion layer in a paste form was prepared by mixing 1 g of P₂O₅-SiO₂-CaO glass particles (P₂O₅: 50%, SiO₂: 43%, CaO: 7%), 0.68 g of ethyl cellulose, and 8.32 g 2-(2-butoxyethoxy)ethyl acetate, without adding an organic filler. The shear viscosity of the composition for forming an n-type diffusion layer was measured by a similar method to Example 1. The results were 200 Pa·s at a shear rate of 0.01/s and 80 Pa·s at 10/s, which were not significantly different. The TI value was as low as 0.40.

The composition for forming an n-type diffusion layer was applied onto the p-type silicon wafer surface and dried by a similar method to Example 1, and the line width was measured. The line width was 270 µm and the expansion from the designed width was 120 µm. The application amount was 2.3 g/m².

The p-type silicon wafer after application of the composition for forming an n-type diffusion layer was subjected to a thermal treatment by a similar method to Example 1, and the sheet resistance was measured. The sheet resistance at a surface on the side applied with the composition for forming an n-type diffusion layer was 40 Ω/□, and it was confirmed that an n-type diffusion layer was formed by diffusion of phosphorus. The sheet resistance at the back side was unmeasurable, namely 1000000 Ω/□ or more, and it was confirmed that an n-type diffusion layer was not formed.

The measurement results of Examples 1 to 5 and Comparative Example 1 are shown in Table 1.

| | | Example 1 | Example 2 | Example 3 | Example 4 | Example 5 | Comparative Example 1 |
|---|---|---|---|---|---|---|---|
| P₂O₅-SiO₂-CaO Glass particles | | 1.0 | 1.0 | 1.0 | 1.0 | 1.0 | 1.0 |
| Ethyl cellulose | | 0.3 | 0.3 | 0.3 | - | 0.29 | 0.68 |
| 2-(2-Butoxyethoxy)ethyl acetate | | 8.6 | 6.7 | 8.6 | 8.3 | 8.7 | 8.32 |
| Organic filler | PMMA (0.1 µm) | 0.1 | 2.0 | - | 0.7 | 0.01 | - |
| | PMMA (5.0 µm) | - | - | 0.1 | - | - | - |
| Shear viscosity (Pa·s) 25°C | Shear rate 10/s | 50 | 80 | 60 | 80 | 80 | 80 |
| | Shear rate 0.01/s | 500 | 5,000 | 300 | 5,000 | 260 | 200 |
| TI value | | 1.00 | 1.80 | 0.70 | 1.80 | 0.51 | 0.40 |
| Expansion in line width (µm) [150 µm screen printing plate] | | 30 | 5 | 50 | 5 | 70 | 120 |
| Top surface sheet resistance (Ω/□) | | 40 | 40 | 40 | 40 | 40 | 40 |
| Back side sheet resistance (Ω/□) | | 10⁶ or more | 10⁶ or more | 10⁶ or more | 10⁶ or more | 10⁶ or more | 10⁶ or more |

In Examples 1 to 5, in which a composition for forming an n-type diffusion layer of the invention includes a compound containing a donor element, a dispersing medium, and an organic filler, exhibit a suppressed expansion in line width as compared with Comparative Example 1. This indicates that a fine line pattern can be formed in a more favorable manner in Examples 1 to 5. Among Examples 1 to 5, Example 2 and Example 4, in which the amount of an organic filler is relatively greater, expansion in line width is more suppressed. This is presumed to be because the shear viscosity at a low shear rate is relatively higher, and an ability or retaining the line width is relatively greater than the other Examples.

The entire contents of the disclosures by Japanese Patent Application No. 2012-037384 are incorporated herein by reference. All the literature, patent literature, and technical standards cited herein are also herein incorporated by reference to the same extent as provided for specifically and severally with respect to an individual literature, patent literature, and technical standard to the effect that the same should be so incorporated by reference.

## Claims

1. A composition for forming an n-type diffusion layer, the composition comprising a compound containing a donor element, a dispersing medium, and an organic filler.

2. The composition for forming an n-type diffusion layer according to claim 1, wherein the organic filler is in a form of particles having an average particle size of 10 µm or less.

3. The composition for forming an n-type diffusion layer according to claim 1 or claim 2, wherein the degradation temperature of the organic filler is 700°C or less.

4. The composition for forming an n-type diffusion layer according to any one of claim 1 to claim 3, wherein the compound containing a donor element is a compound containing phosphorus.

5. The composition for forming an n-type diffusion layer according to any one of claim 1 to claim 4, wherein the compound containing a donor element is in a form of glass particles.

6. The composition for forming an n-type diffusion layer according to claim 5, wherein the glass particles comprise at least one substance containing a donor element selected from the group consisting of P₂O₃ and P₂O₅, and at least one glass component substance selected from the group consisting of SiO₂, K₂O, Na₂O, Li₂O, BaO, SrO, CaO, MgO, BeO, ZnO, PbO, CdO, V₂O₅, SnO, ZrO₂ and MoO₃.

7. The composition for forming an n-type diffusion layer according to claim 5 or claim 6, wherein a content of the glass particles in the composition for forming an n-type diffusion layer is from 1 mass% to 80 mass%.

8. The composition for forming an n-type diffusion layer according to any one of claim 5 to claim 7, wherein a content of the at least one substance containing a donor element selected from the group consisting of P₂O₃ and P₂O₅ in the glass particles is from 0.01 mass% to 10 mass%.

9. The composition for forming an n-type diffusion layer according to any one of claim 1 to claim 8, wherein a content of the organic filler in the composition for forming an n-type diffusion layer is from 1 mass% to 50 mass%.

10. A method for producing a semiconductor substrate having an n-type diffusion layer, the method comprising: a process of applying the composition for forming an n-type diffusion layer according to any one of claim 1 to claim 9 onto at least a part of a semiconductor substrate; and a process of forming an n-type diffusion layer in the semiconductor substrate by performing a heat treatment.

11. A method for producing a photovoltaic cell element, the method comprising: a process of applying the composition for forming an n-type diffusion layer according to any one of claim 1 to claim 9 onto at least a part of a semiconductor substrate; a process of forming an n-type diffusion layer in the semiconductor substrate by performing a heat treatment; and a process of forming an electrode on the n-type diffusion layer.
